# EUROPEAN PATENT APPLICATION

(11) **EP 1 653 518 A2**
(43) Date of publication of application: **03.05.2006**
(21) Application number: 05255377.3
(22) Date of filing: 02.09.2005
(51) Int. Cl.: H01L 29/866, H01L 29/872, H01L 21/329, H01L 21/768, H01L 29/47, H01L 29/45, H01L 23/525, H01L 27/06

(54) **Method of manufacturing a Zener zap diode compatible with tungsten plug technology**

(30) Priority: 30.09.2004 US 956894
(71) Applicant: Micrel, Inc., San Jose, CA 95131 (US)
(72) Inventor: McCormack, Steve, Mountain View CA 94043 (US); Yoo, Ji-hyoung, Cupertino CA 95014 (US); Rossman, Dennis, Sunnyvale CA 94086 (US); Brown, Kevin, Santa Clara CA 95051 (US)
(74) Representative: Pingree, Oliver Norman

(57) **Abstract**

A zener zap device is formed in a fabrication process using a tungsten plug process having standard sized contact openings. The zener zap device includes first and second regions of opposite conductivity types formed in a semiconductor layer. A dielectric layer overlaying the surface of the semiconductor layer includes first and second contact openings positioned above and exposing a portion of the first and second regions respectively. The first contact opening is an enlarged contact opening having dimensions larger than the standard sized contact opening. A first metal contact formed in the first enlarged contact opening includes tungsten sidewall and aluminum formed in electrical contact with the exposed surface of the first region. In one embodiment, the second contact opening is also an enlarged contact opening for forming a second metal contact having tungsten sidewall and aluminum in electrical contact with the exposed surface of the second region.

## Description

### FIELD OF THE INVENTION

The invention relates to zener zap devices and, in particular, to a zener-zap device structure that is compatible with tungsten plug technology.

### DESCRIPTION OF THE RELATED ART

Trimming is a technique used to improve the accuracy and yield of precision integrated circuits. Trimming is usually performed after an integrated circuit has been fabricated and tested to modify or fine tune the performance of the integrated circuit. Zener zap diodes (or zener diodes) are devices that are often used for trimming of integrated circuits. In operation, the zener zap diodes are biased so that they behave as an open circuit as fabricated. When trimming is performed, the zener zap diode is zapped and the junction is short-circuited. Typically, the resistance across the diode reduces to about 10Ω which is treated as equivalent to a "short circuit." By shorting out selective zener zap diodes and thus the associated resistive elements, a desired change in resistance value is obtained.

In general, zener zap diodes are formed as a p-n junction of a heavily doped n+ diffusion and a moderately doped p-type diffusion. The doping level in the more lightly doped p-type diffusion usually determines the junction breakdown voltage. The higher the doping, the lower the breakdown voltage. For cost savings, zener zap diodes are usually constructed using existing layers and diffusions in the CMOS or bipolar fabrication process in which the diodes are to be incorporated. It is common to use the emitter-base junction of a standard NPN transistor device as the zener zap element.

To form the low resistive connection, zener zap diodes require the electromigration of a metal, usually aluminum, from anode to cathode of the zener zap diode, forming a metal filament. In mature technologies where the metallization contact structure allows the aluminum to make direct contact with the silicon, the metal filament created by the electromigration of aluminum in silicon is easily formed.

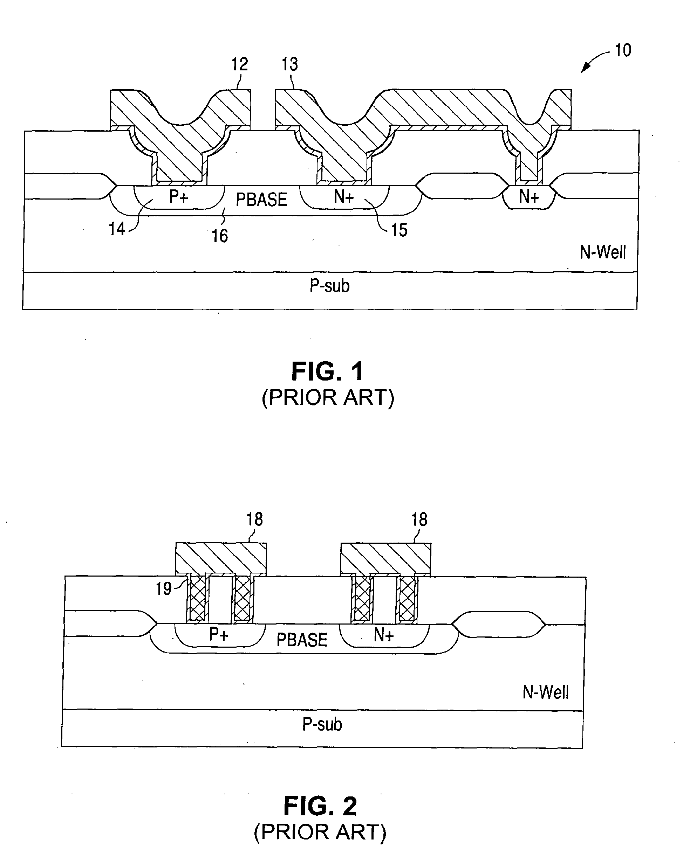

In technologies where aluminum spiking is a concern, a barrier metal consisting of some refractory metal, such as TiN or TiW, is used to prevent aluminum from directly contacting the silicon surface. Figure 1 is a cross-sectional view of a zener zap diode formed in a conventional fabrication process using aluminum and a barrier metal. In Figure 1, zener zap diode 10 includes metallization contacts 12, 13 made to a P+ region 14 and an N+ region 15 formed in a P-Base region 16. In the metallization contacts shown in Figure 1, the aluminum is insulated from the silicon substrate by the barrier metal. Because the barrier metal is typically very thin, during the zapping process, there is usually sufficient heating of the junctions to cause the barrier metal to breakdown and allow an aluminum filament to flow in the silicon between anode and cathode of the zener zap diode. Of course, in some fabrication processes, the barrier metal may be absent from the contact area so that the aluminum contacts the silicon surface directly.

However, in deep submicron technologies (typically 0.5um and below) aluminum cannot adequately cover the contact openings, and the industry has gone to the use of tungsten plugs. In the tungsten plug technology, the tungsten (W) completely fills the contact openings. Aluminum lines are formed on top of the contact openings to interconnect the contacts. Therefore, in the tungsten plug technology, the aluminum layer is formed far away from the surface of the silicon substrate. For instance, the height of a tungsten plug is typically a few thousand angstroms and thus the aluminum layer can be a few thousand angstroms away from the silicon surface.

The use of the tungsten plug technology in a fabrication process makes forming zener zap diodes almost impossible because zener zap diodes require the aluminum to be near the silicon surface so as to form a metal filament when zapped. Figure 2 illustrates the result of forming a zener zap diode using a conventional tungsten plug technology. When W-plug is used to fill the contacts, the aluminum layer 18 is formed on the top of the tungsten plug contacts 19 and is a few thousand angstroms away from the silicon surface where the aluminum needs to be for zapping to occur. Thus, when a zener zap diode is formed as shown in Figure 2, the zener zap diode cannot be programmed properly.

Another limiting feature of using tungsten plugs is that the tungsten plug process is optimized for a specific size for the contact opening so that all tungsten plug contacts formed on the wafer or the integrated circuit must have the same dimension. Specifically, the tungsten plug process is optimized so that the tungsten will consistently fill a contact cavity of a specific size. If the contact size is too small or too large, the contact cavity may not be filled adequately. Thus, in a tungsten plug process, the design rule requires all the metal contact to have a standard size or to be minimally sized and generally does not allow contact sizes to deviate from the standard size.

The typical tungsten plug process is as follows. The silicon wafer with the contact openings defined by a dielectric layer is subjected to a chemical vapor deposition process. The nucleation mechanics grow tungsten from the sides of the contact openings until the tungsten layer fills the cavity. A seam in the center area of the plug often results from the formation of the tungsten as the tungsten grows on the sides and merges to the center. The center seam sometimes can be observed in a scanning electronic microscope photograph of a cross-section of a W-plug contact. Such a center seam is not shown in the cross-sectional view of Figure 2 or the following figures for simplicity sake. However, it is understood that a tungsten plug is sometimes illustrated as including a center seam in a cross-section.

It is desirable to form a zener zap diode in a fabrication process using tungsten plugs where the zener zap diode can programmed properly by the formation of a metal filament.

### SUMMARY OF THE INVENTION

According to one embodiment of the present invention, a zener zap device is formed in a fabrication process using a tungsten plug process where the tungsten plug process dictates standard sized contact openings. The zener zap device includes a semiconductor layer, a first region of a first conductivity type formed in the semiconductor layer, a second region of a second conductivity type formed in the semiconductor layer, and a dielectric layer formed overlaying the top surface of the semiconductor layer. The dielectric layer has a first contact opening and a second contact opening positioned above and exposing portions of the first region and the second region respectively. The first contact opening is an enlarged contact opening having dimensions larger than the standard sized contact opening. The zener zap device further includes a first metal contact formed in the first enlarged contact opening where the first metal contact includes tungsten formed on the sidewall of the first enlarged contact opening and aluminum formed in electrical contact with the exposed surface of the first region.

In one embodiment, the zener zap device includes a second metal contact that is formed as a standard tungsten plug contact. Thus, the second metal contact includes a tungsten plug formed in the second contact opening and aluminum formed on the top surface of the tungsten plug and in electrical contact with the tungsten plug.

In another embodiment, the second contact opening of the zener zap device is a second enlarged contact opening and a second metal contact formed in the second enlarged contact opening includes tungsten formed on the sidewall of the second enlarged contact opening and aluminum formed in electrical contact with the exposed surface of the second region.

According to another aspect of the present invention, a Schottky diode is formed in a fabrication process using a tungsten plug process where the tungsten plug process dictates standard sized contact openings. The Schottky diode includes a semiconductor layer, a first region of a first conductivity type formed in the semiconductor layer where the first region is lightly doped, and a second region of the first conductivity type formed in electrical contact with the first region and is heavily doped. The Schottky diode further includes a dielectric layer formed overlaying the top surface of the semiconductor layer.
The dielectric layer has a first contact opening and a second contact opening positioned above and exposing a portion of the first region and a portion of the second region respectively. The first contact opening is an enlarged contact opening having dimensions larger than the standard sized contact opening. The Schottky diode includes a first metal contact formed in the first enlarged contact opening where the first metal contact includes tungsten formed on the sidewall of the first enlarged contact opening and aluminum formed in electrical contact with the exposed surface of the first region. Finally, the Schottky diode includes a second metal contact formed in the second contact opening where the second metal contact includes a tungsten plug formed in the second contact opening and aluminum formed on the top surface of the tungsten plug and in electrical contact with the tungsten plug.

In one embodiment, the first region is an N-well region and the second region is an N+ region formed in the N-well.

The present invention is better understood upon consideration of the detailed description below and the accompanying drawings.

### BRIEF DESCRIPTION OF THE DRAWINGS

Figure 1 is a cross-sectional view of a zener zap diode formed in a conventional fabrication process using aluminum and a barrier metal.

Figure 2 illustrates the result of forming a zener zap diode using a conventional tungsten plug technology.

Figures 3 and 4 illustrate the process steps for forming a zener zap diode in a fabrication process using a tungsten plug technology according to one embodiment of the present invention.

Figure 5 is a cross-sectional view of a zener zap diode according to an alternate embodiment of the present invention.

Figure 6 is a cross-sectional view of a zener zap diode according to an alternate embodiment of the present invention.

Figure 7 is a cross-sectional view of a zener zap diode according to an alternate embodiment of the present invention where the zener zap diode can be zapped in forward bias mode.

Figure 8 is a cross-sectional view of the zener zap diode of Figure 7 after programming illustrating the formation of the metal filament between the anode and the cathode.

Figure 9 is a cross-sectional view of a zener zap diode according to an alternate embodiment of the present invention formed in a CMOS fabrication process.

Figure 10 is a cross-sectional view of a degenerate zener zap diode formed using enlarged contact openings according to one embodiment of the present invention.

Figure 11 is a cross-sectional view of a conventional Schottky diode.

Figure 12 is a cross-sectional view of a Schottky diode according to one embodiment of the present invention.

### DETAILED DESCRIPTION OF THE PREFERRED EMBODIMENTS

In accordance with the principles of the present invention, a zener zap diode formed in a fabrication process using a tungsten plug technology uses an enlarged contact opening to form the anode or the cathode or both of the zener zap diode. The use of an enlarged contact opening results in the formation of tungsten spacers along the sidewall of the contact opening and allows the overlying aluminum to reach down into the bottom of the contact opening to be near the silicon surface. A zener zap diode thus formed can be programmed properly by the formation of an aluminum filament between the anode and the cathode as the aluminum layer is either directly contacting the silicon substrate surface or separated from the silicon substrate by only a thin barrier metal layer.

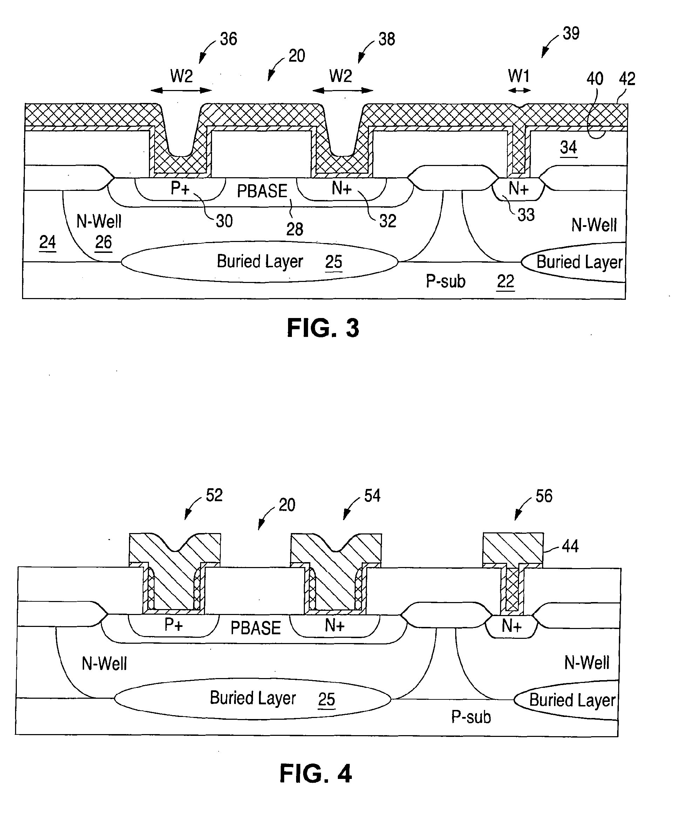

Figures 3 and 4 illustrate the process steps for forming a zener zap diode in a fabrication process using a tungsten plug technology according to one embodiment of the present invention. Referring to Figure 3, a zener zap diode 20 is formed in an N-well 26 which is formed in an epitaxial layer 24 on a P-type silicon substrate 22. The epitaxial layer can be an N-type or a P-type Epi-layer. In the present embodiment, it is assumed that the fabrication process is a bipolar process or a BiCMOS process and a buried layer 25 is generally formed at the bottom of N-well 26. Buried layer 25 is optional and is not critical to the zener zap diode structure of the present invention. In the present embodiment, zener zap diode 20 is formed in a P-base region 28. A P+ region 30 in P-base region 28 forms the anode of the zener zap diode while an N+ region 32 in P-base region 28 forms the cathode of the zener zap diode. P-base region 28 is generally more lightly doped than heavily doped N+ region 32 and P+ region 30. A dielectric layer 34 is then formed over the silicon structure.

To make electrical connection to the anode and the cathode of zener zap diode 20, contact openings 36 and 38 are formed in dielectric layer 34. In Figure 3, a third contact opening 39 is formed for making an electrical contact to an N+ region 33. Contact opening 39 is not part of the zener zap circuit and is provided as a reference structure only. According to the present invention, contact openings 36 and 38 for zener zap diode 20 are enlarged openings having a diameter of width W2. On the other hand, other contact openings on substrate 22, such as contact opening 39, have a standard sized or minimally sized opening of width W1. Width W2 is greater than width W1 sufficient to allow the subsequently deposited tungsten to be removed from the enlarged openings, as will be explained in more detail below.

**.** After the contact openings are formed, a barrier metal layer 40 consisting of a refractory metal, such as TiN or TiW, is deposited on all exposed surfaces of the silicon structure.
Then, the tungsten plug process begins. In the present embodiment, a two-step tungsten plug process is used and the process is generally referred to as a Deposition/Etch back in-situ process. First, a layer of tungsten 42 is deposited on top of barrier metal 40, such as by chemical vapor deposition (CVD).
The nucleation mechanics causes the tungsten to grow on the sidewalls of the contact openings and on the top surface of the dielectric layer, as shown in Figure 3. After the tungsten deposition process, standard sized contact openings, such as contact opening 39, are filled with tungsten to form a plug with additional tungsten layer formed on the top of the plug. In the enlarged contact openings, such as openings 36 and 38, the tungsten layer is deposited conformally over the sidewalls and the bottom surface of the contact openings.

After the deposition of the tungsten layer, a blanket etch back process is carried out. The etch back process is sometimes carried out in-situ - that is, in the same process chamber as the deposition without breaking vacuum. The etch back process is typically a plasma etch process and is anisotropic.
Barrier metal layer 40 acts as the etch-stop for the etch back process. Figure 4 is a cross-sectional view of the silicon structure including zener zap diode 20 after the tungsten etch-back process. After the anisotropic etch process, all the tungsten that is on the top of the dielectric layer is removed, leaving the tungsten that fills the standard sized contact opening 39. A tungsten plug is thus formed in contact opening 39. In the enlarged contact openings 36 and 38, the conformal tungsten layer is etched so that only sidewall portions of the tungsten layer remain in the enlarged contact openings. The bottom of the enlarged contact openings is thus exposed, that is, not covered by any tungsten material. The barrier metal layer that is on the bottom surface of the contact openings may be partially etched but usually remains after the tungsten etch back process.

Next, an aluminum layer 44 is deposited on the silicon structure and patterned to form metal contacts 52, 54 and 56. Metal contact 56 is a standard tungsten plug contact where the aluminum layer is formed above the tungsten-filled contact opening. On the other hand, metal contacts 52 and 54 are formed from enlarged contact openings so that the tungsten layer forms only sidewall portions along the contact openings and the aluminum layer fills the cavity of the contact openings. Metal contacts 52 and 54 thus have aluminum that reached to the bottom of the contact openings where the aluminum is separated from the silicon surface only by the thin barrier metal layer.

Zener zap diode 20 thus formed, including enlarged metal contacts 52 and 54, is well suited for zapping as the aluminum layer is formed close to the silicon surface to allow the necessary metal filament to be formed when the zener zap diode is programmed by the application of the appropriate programming voltage and current.

In some fabrication process, a second barrier metal may be deposited prior to the aluminum deposition. Then, there may be two layers of barrier metal on the bottom of the enlarged contact openings before the aluminum is deposited. Such a zener zap diode can still be zapped to form a metal filament as the metal barrier layers can still breakdown under normal zapping conditions. Of course, the barrier metal is optional and the zener zap diode of the present invention can be formed using fabrication processes that do not employ any barrier metal layer at all.

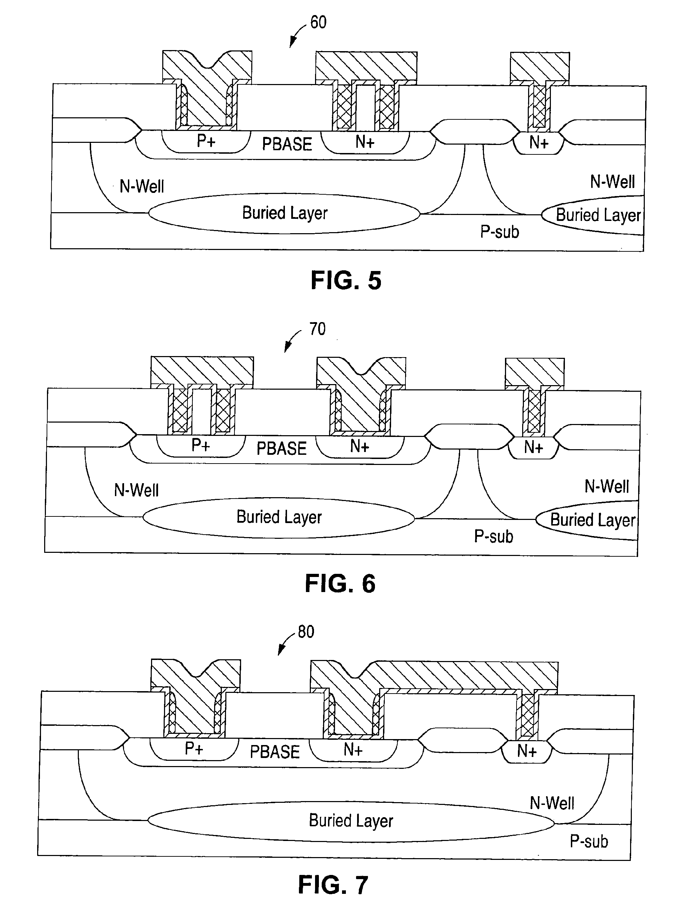

In the embodiment shown in Figure 4, zener zap diode 20 includes two enlarged contacts for both the anode and the cathode terminals of the diode. In other embodiments, the zener zap diode can be formed with only one enlarged contact for either the anode or the cathode terminal. Figure 5 is a cross-sectional view of a zener zap diode 60 where the anode contact is made with an enlarged contact and the cathode contact is made using standard sized tungsten plugs. Figure 6 is a cross-sectional view of a zener zap diode 70 where the cathode contact is made with an enlarged contact and the anode contact is made using standard sized tungsten plugs. In the embodiments shown in Figures 5 and 6, two tungsten plugs are used for the anode or cathode contact. This is illustrative only and in other embodiments, only one tungsten plug may be used for the standard sized contacts.

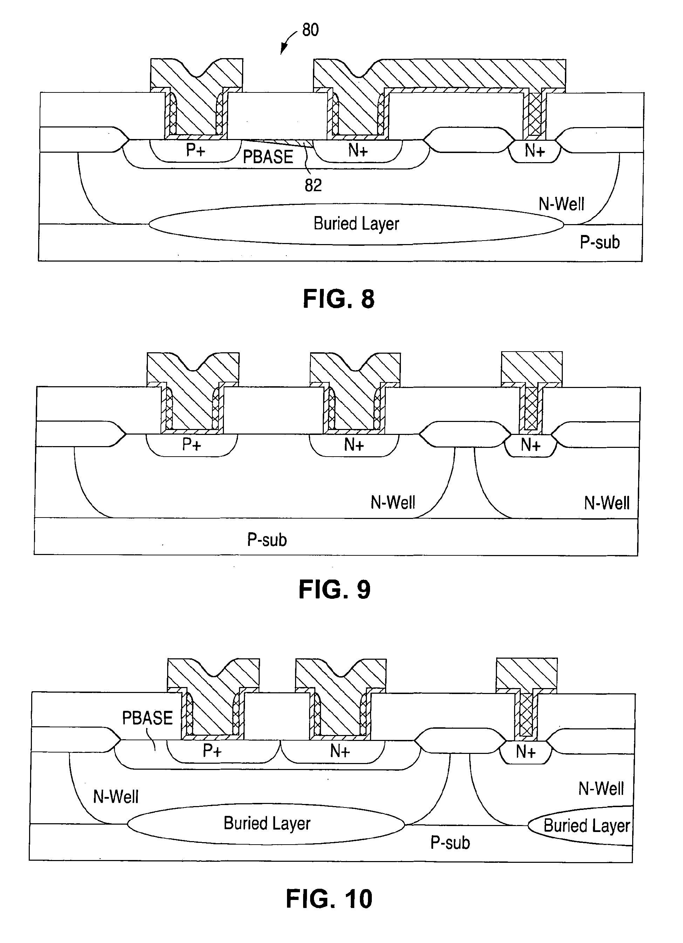

Furthermore, in the embodiments shown in Figures 4-6, the zener zap diodes are zapped under the reverse bias direction. However, in other embodiments, the zener zap diodes can be zapped in the forward bias direction. When forward bias zapping is used, the cathode contact may be electrically shorted to the N-well as shown in Figure 7. When zener zap diode 80 of Figure 7 is zapped, a metal filament 82 is formed shorting the N+ cathode region and the P+ anode region, as shown in Figure 8.

In the above embodiments, the zener zap diode is described as being fabricated in a bipolar or BiCMOS process and the zener zap diode is formed in a P-base diffusion region. The zener zap diode of the present invention can be formed in other fabrication processes employing a tungsten-plug technology.
Figure 9 is a cross-sectional view of a zener zap diode formed using a CMOS fabrication process according to one embodiment of the present invention. The P+ anode region and the N+ cathode region are formed directly in an N-well.

Furthermore, in the above-described embodiments, the silicon structure in which the zener zap diodes are formed includes an epitaxial layer. The use of epitaxial layer is illustrative only and may be omitted in fabrication processes not using an epitaxial layer. In that case, the zener zap diode will be formed in the substrate as with the other devices formed on the substrate.

In yet another alternate embodiment of the present invention, a degenerate zener zap diode can be formed by using P+ anode region and N+ cathode region that are contiguous or merged, as shown in Figure 10. That is, the distance between the P+ region and the N+ region in the above described embodiments can be zero or larger, such as up to 5 microns. When the P+ and N+ regions are contiguous, the zener zap diode thus resulted may be leaky but the diode can still be zapped. Circuitry can be provided to measure the decrease in resistance in the diode to determine if the diode has been zapped. Degenerate zener diodes can have resistance permanently decreased due to heating and damages at the junction before zapping actually occurred.

In the above descriptions, the tungsten plug process is described as being a deposition/etch-back process. The zener zap diode of the present invention can also be formed in a tungsten plug process that uses chemical mechanical polishing (CMP) to remove the tungsten instead of the etch-back process. When the tungsten process involves CMP, the tungsten in the enlarged contact openings can be removed by using a selective etch process after the CMP step is applied to remove the tungsten formed on the top surface of the dielectric layer. That is, the standard sized tungsten plugs can be masked by using a photoresist and the exposed enlarged sized contacts can then be subject to an anisotropic etch process to remove tungsten from the enlarged openings. Other process step variations are possible to realize the formation of aluminum contacts in a tungsten plug process for forming zener zap diodes in accordance with the present invention.

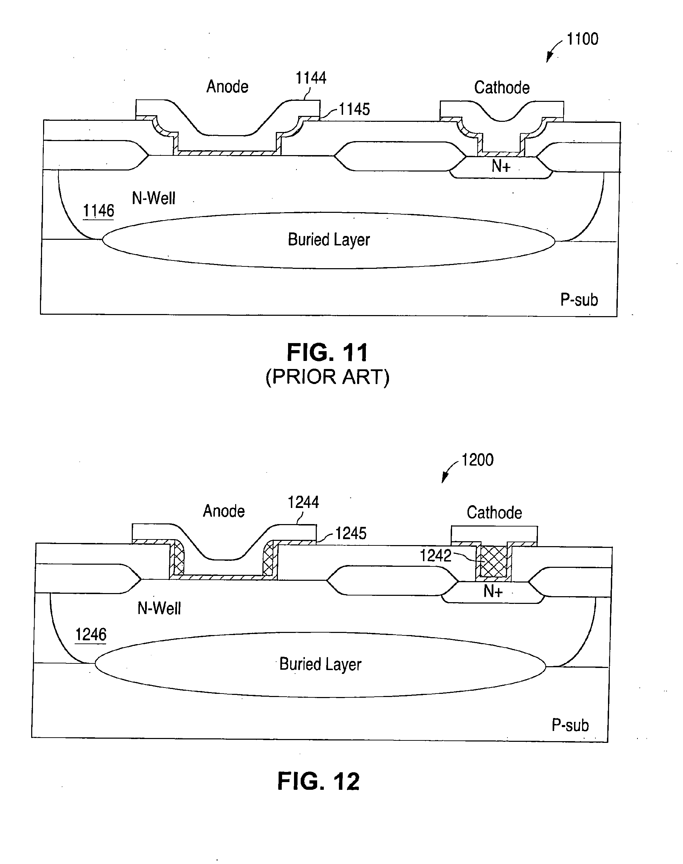

According to another aspect of the present invention, the enlarged sized contacts can be used advantageously in a tungsten-plug process for forming a Schottky barrier diode. As is well understood in the art, a Schottky barrier diode (or a "Schottky diode") is formed by a metal-semiconductor junction. Typically, aluminum is used as the metal for the Schottky diode. When the fabrication uses a tungsten-plug process, a Schottky diode will have to be formed using tungsten as the metal. Figure 11 is a cross-sectional view of a conventional Schottky diode.
As shown in Figure 11, the anode of the Schottky diode is formed by the contact of an aluminum layer 1144 with the surface of a lightly doped N-type semiconductor which is an N-well 1146 in the present illustration. The cathode of the Schottky diode is formed by an N+ region in electrical contact with N-well 1146. Note that the anode contact opening is larger than the cathode contact opening to provide more contact surface for the aluminum-silicon interface. In aluminum contact technology, it is possible to use different contact sizes as the conventional aluminum deposition processes generally permit filling of aluminum in contact openings of different sizes. In Figure 11, a barrier metal 1145 is included underneath aluminum layer 1144 where such barrier metal layer is optional and is typically used to prevent aluminum spiking, as is well understood in the art.

When a fabrication process employs a tungsten plug technology; the formation of a Schottky diode in such a process faces the same challenge as the formation of a zener zap diode. That is, when tungsten plugs are used, the aluminum is no longer in close proximity to the silicon surface but rather is separated from the silicon surface by the height of the tungsten plug. Also, the contact size in a tungsten plug technology is fixed and minimally sized contacts must be used to ensure proper tungsten plug formation. The interface between tungsten and silicon does not form a satisfactory Schottky diode for various reasons. For instance, tungsten has higher resistance than aluminum and tungsten plugs require minimally sized contact opening. Thus, the overall resistance of a Schottky diode formed using tungsten plugs or an array of tungsten plugs can be very high. Therefore, it is often desirable to form an aluminum-silicon Schottky diode in a fabrication process that uses tungsten plug technology.

In accordance with the present invention, a Schottky diode formed in a fabrication process employing a tungsten plug technology uses an enlarged contact opening to form the anode of the diode so that an aluminum-semiconductor interface is realized. The use of an enlarged contact opening allows the aluminum overlying the tungsten to reach down into the bottom of the contact opening to be near the silicon surface. A Schottky diode thus formed provides the desired Schottky diode characteristics as the aluminum layer is either directly contacting the silicon substrate surface or separated from the silicon substrate by only a thin barrier metal layer.

Figure 12 is a cross-sectional view of a Schottky diode according to one embodiment of the present invention. Referring to Figure 12, a Schottky diode 1200 is formed using a fabrication process that employs a tungsten plug technology. An enlarged contact opening is used to form the anode of the Schottky diode so that when the tungsten deposition and etch back processing steps are carried out, only tungsten sidewalls remain in the enlarged contact opening. When an aluminum layer 1244 is deposited and patterned, the aluminum reaches to the bottom of the oversized contact opening and is either contacting the lightly doped N-type silicon surface in N-well 1246 directly or through a thin barrier metal 1245 (TiSi2, with Ti or TiN) as shown in Figure 12. The cathode contact of Schottky diode 1200 can be formed as a standard tungsten plug contacting an N+ region in electrical contact with N-well 1246. In the present embodiment, the N+ region is formed in N-well 1246. In other embodiments, other means for contacting N-well 1246 are also possible, such as by the use of a sinker diffusion region contacting the buried layer. The N+ region can then be formed in the sinker diffusion region. Schottky diode 1200, as formed in accordance with the present invention, has the desired Schottky diode characteristics that cannot be achieved with the use of tungsten plugs for the anode contact.

In Figure 12, a barrier metal layer 1245 of TiSi2, and Ti or TiN is formed underneath the tungsten and aluminum layers and functions as an etch stop for the tungsten etch back process. By using the TiSi2/TiN/Aluminum metalization scheme from a conventional aluminum spiking barrier metal process, the Schottky diode of the present invention thus formed in a tungsten-plug fabrication process can have the same work function and electrical properties as a conventional Schottky diode formed in an aluminum contact fabrication process.

The aluminum-silicon Schottky diode as formed in Figure 12 provides many advantages over a tungsten-silicon Schottky diode. First, the enlarged contact allows aluminum to directly contact the barrier metal and realizes an increase in the effective active area of the resultant Schottky diode where the effective active area is the actual Schottky junction of the Schottky diode. Specifically, for a given silicon area allocated for a Schottky diode, the effective active area of a tungsten-silicon Schottky diode formed using an array of minimally sized tungsten plug contacts is only about the square root of the effective active area of an aluminum-silicon Schottky diode formed using an enlarged contact. Thus, the aluminum-silicon Schottky diode of the present invention, when used in a tungsten-plug fabrication process, can realize a significant increase in the area of the Schottky diode junction for a given silicon area. Second, since aluminum has lower resistance than tungsten (up to three times lower in resistance), the overall resistance of the Schottky diode of a given area is reduced. Reducing the resistance of the Schottky diode is important when the Schottky diode is used in a high power application.

The above detailed descriptions are provided to illustrate specific embodiments of the present invention and are not intended to be limiting. Numerous modifications and variations within the scope of the present invention are possible. The present invention is defined by the appended claims.

## Claims

1. A zener zap device (20, 60, 70) formed in a fabrication process using a tungsten plug process wherein the tungsten plug process dictates standard sized contact openings, the zener zap device comprising:
a semiconductor layer;
a first region (30) of a first conductivity type formed in the semiconductor layer;
a second region (32) of a second conductivity type formed in the semiconductor layer;
a dielectric layer (34) formed overlaying the top surface of the semiconductor layer, the dielectric layer having a first contact opening (36) and a second contact opening positioned above and exposing a portion of the first region and a portion of the second region respectively, the first contact opening being an enlarged contact opening having dimensions larger than the standard sized contact opening;
a first metal contact (52) formed in the first enlarged contact opening, the first metal contact comprising tungsten (42) formed on the sidewall of the first enlarged contact opening and aluminum (44) formed in electrical contact with the exposed surface of the first region; and
a second metal contact formed in the second contact opening, the second metal contact comprising a tungsten plug formed in the second contact opening and aluminum formed on the top surface of the tungsten plug and in electrical contact with the tungsten plug.

2. The zener zap device of claim 1, further comprising:
a third region (28) of the first conductivity type forming in the semiconductor layer, the first region and the second region being formed inside the third region, the third region being more lightly doped than the first and second regions.

3. The zener zap device of claim 1, further comprising:
a barrier metal layer (40) formed in each of first and second metal contacts, the barrier metal being formed at least on the surface of the semiconductor layer under the tungsten and the aluminum.

4. The zener zap diode of claim 1, wherein the first region and the second region are formed spaced apart.

5. The zener zap diode of claim 1, wherein the first region and the second region are contiguous.

6. The zener zap diode of claim 1, wherein the first conductivity type comprises P-type conductivity and the first metal contact comprises a metal contact to the anode of the zener zap diode.

7. The zener zap diode of claim 1, wherein the first conductivity type comprises N-type conductivity and the first metal contact comprises a metal contact to the cathode of the zener zap diode.

8. The zener zap diode of claim 1, wherein the second contact opening (38) comprises an enlarged contact opening having dimensions larger than the standard sized contact opening, and the second metal contact (54) formed in the second enlarged contact opening comprises tungsten formed on the sidewall of the second enlarged contact opening and aluminum formed in electrical contact with the exposed surface of the second region.

9. The zener zap device of claim 8, wherein the semiconductor layer comprises:
a semiconductor substrate (22);
an epitaxial layer (24) formed on the top surface of the semiconductor substrate; and
a first well region (26) of the second conductivity type formed in the epitaxial layer,
wherein the first region and the second region are formed in the first well region.

10. A method for forming a zener zap diode (20, 60, 70) in a fabrication process using a tungsten plug process wherein the tungsten plug process dictates standard sized contact openings, the method comprising:
providing a semiconductor structure;
forming a first region (30) of a first conductivity type in the semiconductor structure;
forming a second region (32) of a second conductivity type in the semiconductor structure;
forming a dielectric layer (34) overlaying the semiconductor structure;
forming first and second enlarged contact openings (36, 38) in the dielectric layer positioned above and exposing a portion of the first region and a portion of the second region respectively, the first and second enlarged contact openings having dimensions larger than the standard sized contact opening;
forming a first metal contact (52) in the first enlarged contact opening, the first metal contact comprising tungsten formed on the sidewall of the first enlarged contact opening and aluminum formed in electrical contact with the exposed surface of the first region; and
forming a second metal contact (54) in the second enlarged contact opening, the second metal contact comprising tungsten formed on the sidewall of the second enlarged contact opening and aluminum formed in electrical contact with the exposed surface of the second region.

11. The method of claim 10, wherein forming a first metal contact in the first enlarged contact opening comprises:
forming a barrier metal layer (40) on the surface of the dielectric layer and the surface of the first enlarged contact opening;
forming a tungsten layer (42) on the surface of the barrier metal layer;
etching back the tungsten layer using an anisotropic etch process, leaving tungsten only on the sidewall of the first enlarged contact opening;
forming an aluminum layer (44) on the surface of the tungsten layer; and
patterning the aluminum layer to form the first metal contact.

12. The method of claim 10, wherein forming a second metal contact in the second enlarged contact opening comprises:
forming a barrier metal layer (40) on second surface of the dielectric layer and the surface of the first enlarged contact opening;
forming a tungsten layer (42) on the surface of the barrier metal layer;
etching back the tungsten layer using an anisotropic etch process, leaving tungsten only on the sidewall of the second enlarged contact opening;
forming an aluminum layer on the surface of the tungsten layer; and
patterning the aluminum layer (44) to form the second metal contact.

13. The method of claim 10, further comprising:
forming a third region (28) of the first conductivity type in the semiconductor structure, the third region being more lightly doped than the first and second regions,
wherein the first region and the second region are formed in the third region.

14. The method of claim 10, wherein forming a second region of a second conductivity type in the semiconductor structure comprises forming a second region of a second conductivity type spaced apart from the first region of the first conductivity type.

15. The method of claim 10, wherein forming a second region of a second conductivity type in the semiconductor structure comprises forming a second region of a second conductivity type contiguous with the first region of the first conductivity type.

16. The method of claim 10, wherein providing a semiconductor structure comprises:
providing a semiconductor substrate (22);
forming an epitaxial layer (24) on the top surface of the semiconductor substrate; and
forming a first well region (26) of the second conductivity type in the epitaxial layer, the first and second regions being formed in the first well region.
